# EUROPEAN PATENT APPLICATION

(11) **EP 1 694 084 A1**
(43) Date of publication of application: **23.08.2006**
(21) Application number: 05101267.2
(22) Date of filing: 18.02.2005
(51) Int. Cl.: H04Q 7/30, H05K 7/18

(54) **Electrical equipment enclosure, method of installing equipment in such an enclosure, and extension device**

(71) Applicant: T-Mobile Netherlands B.V., 2521 CC Den Haag (NL)
(72) Inventor: Ravesloot, Marcel, 2552 HP, Den Haag (NL); Claassen, Evert-Dirk, Ger, 2517 CJ, Den Haag (NL)
(74) Representative: van Lookeren Campagne, Constantijn August

(57) **Abstract**

An electrical equipment enclosure includes a housing (1), provided on at least two sides with cable passage areas, pre-configured for providing an opening for passing through cables from equipment external to the enclosure,
wherein the housing (1) is adapted to accommodate a connecting device (8) providing access to at least one cable connection point (9), and
an extension device (11) for installing an equipment module (10). The housing (1) is adapted to accommodate the connecting device (8) in a position defining cable accommodation spaces, extending from at least two sides of the connecting device (8) to cable passage areas on corresponding sides of the housing (1). The extension device (11) is positioned for installing an equipment module (10) in a position at least partially occupying a cable accommodation space.

## Description

The invention relates to an electrical equipment enclosure including
a housing, provided on at least two sides with cable passage areas, pre-configured for providing an opening for passing through cables from equipment external to the enclosure, wherein the housing is adapted to accommodate a connecting device providing access to at least one cable connection point, and further including
an extension device for installing an equipment module.

The invention also relates to a device for extending the accommodation capacity of an enclosure for accommodating electrical equipment.

The invention also relates to a method of installing an equipment module in an electrical equipment enclosure including
providing a housing provided on at least two sides with cable passage areas, pre-configured for providing an opening for passing through cables from equipment external to the enclosure,
the housing being adapted to accommodate a connecting device providing access to at least one cable connection point.

Respective examples of such an enclosure, device and method are known. DE-A1-100 04 107 describes a base station for a mobile radio communication system. It comprises a basic configuration consisting of one microBTS (micro Base Transceiver Station) and at least one add-on module, which is connected to the basic configuration. The basic configuration is enclosed in a housing, which is extendable by means of the housing of the add-on module to form a complete housing. Electronic packaged circuits comprised in the basic configuration and each of the add-on modules are ordinarily arranged on a support or in a corresponding chassis, known as a rack, through which the power supply and data transfer between the packaged circuits is effected. The basic configuration and each add-on module are preferably provided with a separate temperature control and/or filtering.

A problem of the known arrangement is that additional cooling and/or ventilation capacity must be installed with each further add-on module that is connected to the basic configuration. This is due to the fact that the total volume of the enclosure increases substantially with each extra add-on module.

It is an object of the invention to provide an electrical equipment enclosure, device for extending the accommodation capacity of an enclosure and method of installing an equipment module in an electrical equipment enclosure that combine flexibility of installation with a comparatively high accommodation capacity relative to the internal volume of the enclosure.

This object is achieved according to the invention by providing an electrical equipment enclosure which is characterised in that the housing is adapted to accommodate the connecting device in a position defining cable accommodation spaces, extending from at least two sides of the connecting device to cable passage areas on corresponding sides of the housing, and in that the extension device is positioned for installing an equipment module in a position at least partially occupying a cable accommodation space.

Because cable passage areas are provided on at least two sides, and cable accommodation spaces extend between these and the connecting device, a choice is offered as to the side of the enclosure to which cables from external equipment are led into the enclosure. This provides a desirable degree of flexibility when installing the enclosure. It is possible to install the enclosure in a corner on either side of a room. Because the extension device for installing an equipment module is positioned for installing an equipment module in a position at least partially occupying a cable accommodation space, the available volume is used more efficiently. Accommodation space provided by a cable accommodation spaces that is not used to accommodate cables fed through an opening in the cable passage area from which it extends is used to accommodate the extension device for installing a further equipment module. Because at least a part of the already existing volume is used, the housing's existing cooling and ventilation system can be used. In particular, the impact on the flow of cooling air is quite limited.

In a preferred embodiment, the extension device is releasably mounted to the housing.

This provides further flexibility, in that the extension device can be removed from the cable accommodation space in which it is at least partially positioned.
Preferably, provision is made to mount the extension device in any one of a plurality of available cable accommodation spaces. Thus, the choice of configuration can be kept open until such time as the enclosure is installed in the location where it is to be deployed.

In a preferred embodiment, the extension device extends through an opening provided in the cable passage area to which the cable accommodation space extends.

Thus, the extension device is suitable for installing an equipment module of a larger dimension than that allowed for by the cable accommodation space that it partially occupies. Upon installation of equipment and its connection to external apparatus, cables to the external equipment are fed through an opening in one of the cable passage areas, whereas the extension device is releasably mounted in such a position that it extends through an opening in another of the cable passage areas.

In a preferred embodiment, a cover defining a space expanding the cable accommodation space on an opposite side of the cable passage area to which the cable accommodation space extends, is mounted on an exterior surface of the housing.

Thus, the internal volume of the enclosure is expanded in a continuous manner. Larger equipment modules can be installed in such a manner that they are at least partially shielded from the environment. Complete shielding is provided where the space defined by the cover is completely enclosed around the opening by the cover. Partial shielding, for example to provide ventilation slots, is also conceivable.

In an embodiment, the cover is attached to a side panel of the housing provided with the cable passage area, and at least one bracket for mounting an equipment module is provided on a frame extending from the cover into the cable passage area.

In this embodiment, the extension device comprises both the cover and the frame. It can thus be mounted on the side panel with the opening through which the frame extends. This embodiment is advantageous, because it can comprise housings such as are already commonly in use, for example as enclosures for a Node B in a cellular communications network.

In a preferred embodiment, the electrical equipment enclosure is provided with a climate control system for regulating the temperature inside the housing.

This embodiment allows equipment modules to be installed that give off large amounts of heat, or are sensitive to temperature variations. Because the extension device is positions for installing an equipment module in a position at least partially occupying a cable accommodation space, the equipment module actually installed will also benefit from the climate control regulating the temperature inside the housing.

In an embodiment, a device in a system for controlling an antenna pattern of an antenna system at a site of a base transceiver station of a cellular communications system is mounted in the extension device.

This embodiment advantageously expands the accommodation capacity of existing cabinets for base transceiver stations in use in so-called first and second generation cellular networks, when upgrading the network to third-generation standards. In such third-generation networks, the tilt control is often necessary to ensure adequate coverage of a radio cell of a relatively large size.

In an embodiment, the sides on which cable passage areas are provided extend upwardly relative to a base for mounting the housing on a pedestal.

Thus, cable passage areas can be provided on more sides than would be the case for a wall-mounted housing. In principle, the housing, and thus the extended enclosure comprising the housing, can be freestanding.

In a preferred variant, the cable accommodation spaces are defined at an end of the housing opposite to the base.

This is advantageous when using the equipment enclosure at the foot of an antenna, since external cables from the antenna, through openings in cable passage areas, to the connecting device can be relatively short.

In a preferred embodiment the extension device includes at least one bracket configured to provide mounting points for mounting a rack-mountable module, preferably a standard-sized nineteen-inch unit.

This increases the versatility of the electrical equipment enclosure, since the equipment modules that can be installed using the extension device are not limited to one pre-determined type.

According to another aspect, the invention provides a device for extending the accommodation capacity of an enclosure for accommodating electrical equipment, which device comprises an extension device presenting all the features of the extension device disclosed in an electrical equipment enclosure according to the invention and is thus constructed and evidently intended for use in the electrical equipment enclosure according to the invention.

According to another aspect, the method according to the invention of installing an equipment module in an electrical equipment enclosure is characterised by providing a housing adapted to accommodate the connecting device in a position defining cable accommodation spaces, extending from at least two sides of the connecting device to cable passage areas on corresponding sides of the housing and mounting the equipment module in a position at least partially occupying a cable accommodation space.

The method has the advantage of leaving open to which side cables from external equipment are fed into the enclosure and on which side the equipment module is installed until installation actually takes place. At the same time, a minimum of space is left unused upon installation.

Preferably, an extension device is mounted in the electrical equipment enclosure, and the equipment module is mounted in the extension device.

This has the advantage that the housing of the equipment enclosure need not be particularly adapted to the equipment module to be installed. Adaptation is effected largely by the act of mounting of the extension device.

A preferred embodiment includes mounting the extension device so as to extend through the opening provided in one of the cable passage areas.

This embodiment has the advantage of increasing the allowable size of the equipment module in at least one dimension.

The invention will now be explained in further detail with reference to the accompanying drawings.
Fig. 1 is a frontal view of an embodiment of an equipment enclosure for implementation of a Base Transceiver Station;
Fig. 2 is a cross-sectional view from above of the equipment enclosure;
Fig. 3 is a cross-sectional view corresponding to Fig. 2 and additionally showing connections to external equipment;
Figs. 4A-4D are rear, top, side and frontal views of an extension device for use in the equipment enclosure; and

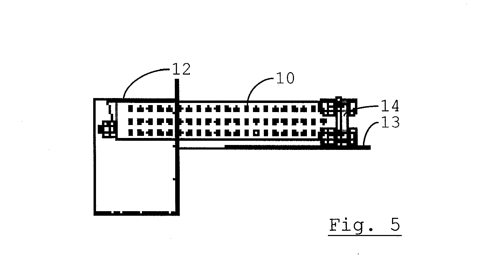

Fig. 5 is a side view of the extension device with an installed equipment module.

An example of an electrical equipment enclosure that is suitable for implementing a Base Transceiver Station (BTS) in a cellular wireless network is illustrated herein. The BTS supports one or more wireless network access standards, such as GSM/EDGE, CDMA2000 or WCDMA. Such networks are built up of cells. A cell is a radio network object that can be uniquely identified by a User Equipment, such as a handset, from an identification that is broadcast over a geographical area from one radio node. Node B is the term used to denote a logical node responsible for transmission/reception in one or more cells to and from the User Equipment. The physical implementation is in the form of a BTS site, on which are provided one or more antennas (not shown) and electronic equipment modules in a suitable enclosure, forming the BTS. The enclosures come in a limited number of variants, for outdoor and indoor use for example, and sizes. Preferred embodiments include a plurality of shelves, which may include card slots for insertion of card-shaped Printed Circuit Board (PCB) modules and a back plane for interconnecting and supplying power to the modules. To prevent signal degradation, the BTS is preferably provided as close to the antenna as possible, for example at the foot of the antenna mast. A more detailed description of a BTS architecture is given in, for example, "BTS System Reference Document", Version 1.0, Open Base Station Architecture Initiative.

Although the present disclosure is largely confined to the example of a BTS for a so-called third-generation cellular network, the principles disclosed herein also find advantageous application in equipment enclosures for implementing other types of communication networks. Examples include enclosures for a base station for implementing a Wireless Local Loop infrastructure.

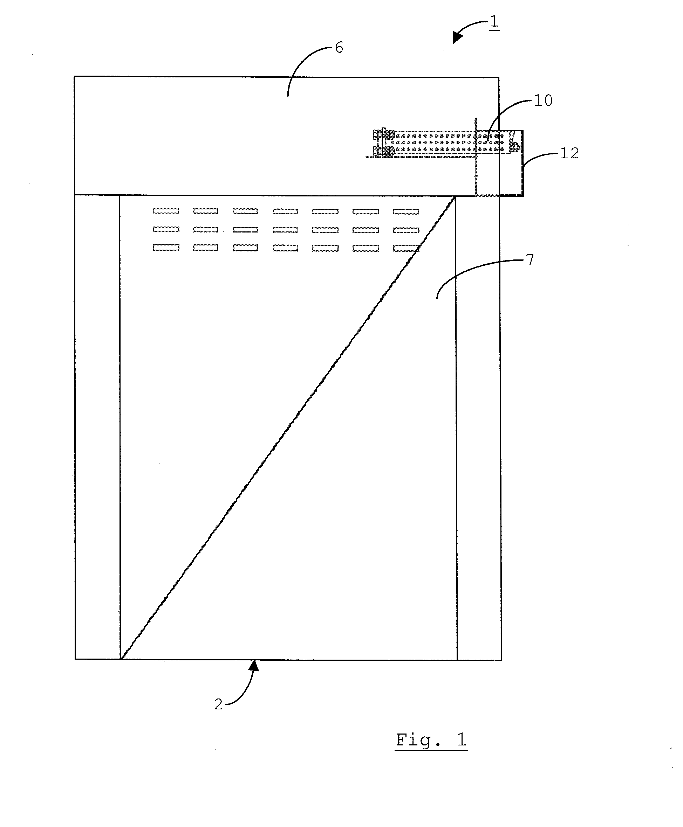

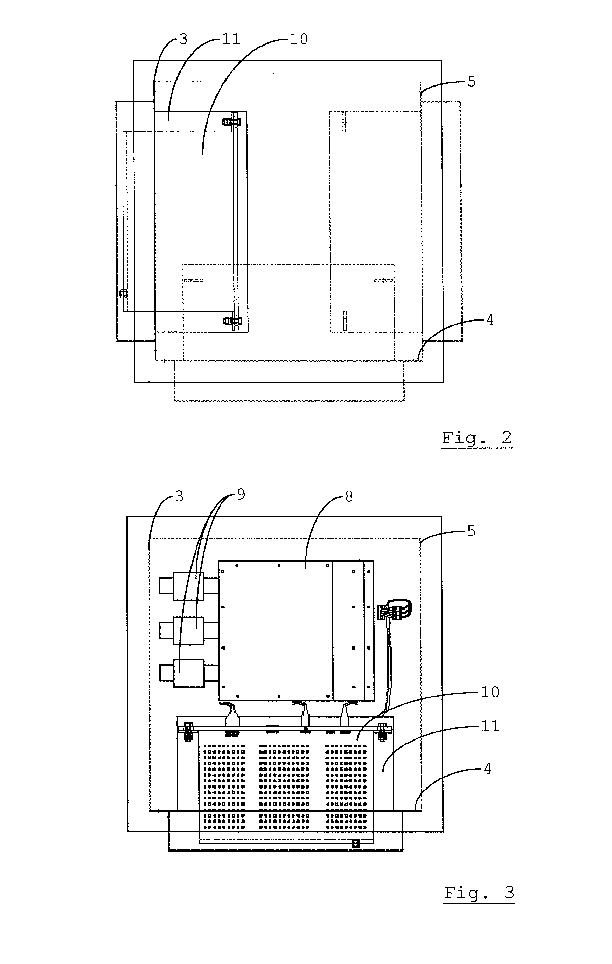

The illustrated enclosure comprises a housing 1 comprising a base 2, a top side and four further sides. One or more panels on each side define an interior space of the housing 1, arranged to accommodate equipment modules. In the illustrated embodiment, first, second and third side panels 3-5 (Figs. 2 and 3) bound a part of the interior of the housing 1 at the top end of the housing 1, opposite the base 2. These side panels 3-5 are covered by a hood 6 (Fig. 1). The hood 6 is attached to the rest of the housing 1 by hinges (not shown). Openings (not shown) are present in the hood 6 on the three sides other than the front side of the housing 1, on which a front door 7 is provided.

The first, second and third side panels 3-5 are continuous, except for apertures (not shown), provided in cable passage areas defined in each of them. Provision has also been made for mounting respective blind plates to close off the apertures. Thus, the cable passage areas with covered apertures are pre-configured for providing an opening. In alternative embodiments, the pre-configuration is effected by providing panels with contours of apertures. The panel is reduced in thickness along the contour by scoring, stamping, providing perforations or similar processing. The actual opening can then be provided by pushing out the outlined part of the panel when installing the equipment in the enclosure. In some alternative embodiments, cable passage areas are pre-configured to provide a plurality of openings. The openings are of dimensions suitable for passing through one or more cables from equipment external to the housing 1.

Referring to Fig. 3, a connecting device 8 is situated in the interior of the housing 1 at substantially the level of the side panels 3-5 relative to the base 2. The connecting device 8 provides access to, in this example, three connectors 9 for connecting cables providing a connection to equipment external to the housing 1. When equipment is installed inside the equipment enclosure, the cables are led through an opening provided in the cable passage area of at least one of the side panels 3-5. Upon connection, they extend through a part of the interior of the housing 1 referred to herein as a cable accommodation space. Cable accommodation spaces are present on three sides of the connecting device 8 in the illustrated embodiment. Each cable accommodation space extends from one side of the connecting device 8 to a cable passage area in one of the side panels 3-5 facing that side. The cable accommodation space extends to the corresponding side of the housing 1, which is that more or less flat surface of the housing 1 bounding its interior that is substantially parallel and closest to the respective surface bounding the connecting device 8. To reduce the required length of the cables, the connecting device 8 is preferably positioned at substantially the same level relative to the base 2 as the cable passage areas. This is not essential, however.

The connecting device 8 can be a device specially adapted for providing an interface between external equipment and any of a plurality of equipment modules installed in the equipment enclosure. For example, it can be the power supply, an antenna amplifier or such like. It can also be a device that is dedicated to a specific function that requires a connection to external equipment. In that sense, it need not be the only device present in the housing 1 that provides access to a cable connection point. The term cable connection point is used herein to refer to a feature allowing a cable to be connected. Examples include connectors for mating with a connector of the cable, wire terminals with clamping mechanisms, etc.

The housing 1 described thus far is of a known type. Examples of such a housing 1 are available under the product name UltraSite from Nokia. Such housings 1 have found widespread use in BTSs for cellular communications networks of the first and second generations. Ordinarily, an opening provided in a cable passage area on one side of the housing 1 is used to feed through cables from, for example, an antenna. These then occupy one of the cable accommodation spaces. In the example shown in Figs. 2 and 3 in particular, the other two cable accommodation spaces would be left empty. A climate control system (not shown) regulates the temperature over the entire interior volume of the housing 1, and comprises one or more heating devices and a ventilation system.

To accommodate the additional equipment required to implement a Node B in a third-generation cellular communications network, an equipment module 10 is mounted in a position at least partially occupying one of the normally empty cable accommodation spaces.

In principle, the equipment module 10 can be chosen to fit into the chosen cable accommodation space, so that it is mounted in a position in which it fully occupies the cable accommodation space. By this, it is meant that the entire equipment module occupies a volume within the cable accommodation space. In the embodiment illustrated in Fig. 3, however, the equipment module 10 is mounted in a position partially occupying the normally empty cable accommodation space and partially occupying a volume on an opposite side of the second side panel 4.

To this end, an extension device 11 is provided. The extension device 11 is releasably mounted to the housing 1, more particularly to the second side panel 4 in Fig. 3. Being releasably mounted, the extension device 11 can be easily mounted and dismounted by mechanical actions. Thus, it can be mounted to the first side panel 3, as shown in Fig. 2, instead of the second side panel 4. This presupposes a different location for the connecting device 8 than in Fig. 3, in order to mount the equipment module 10 in another one of the cable accommodation spaces not already occupied by cables from external equipment.

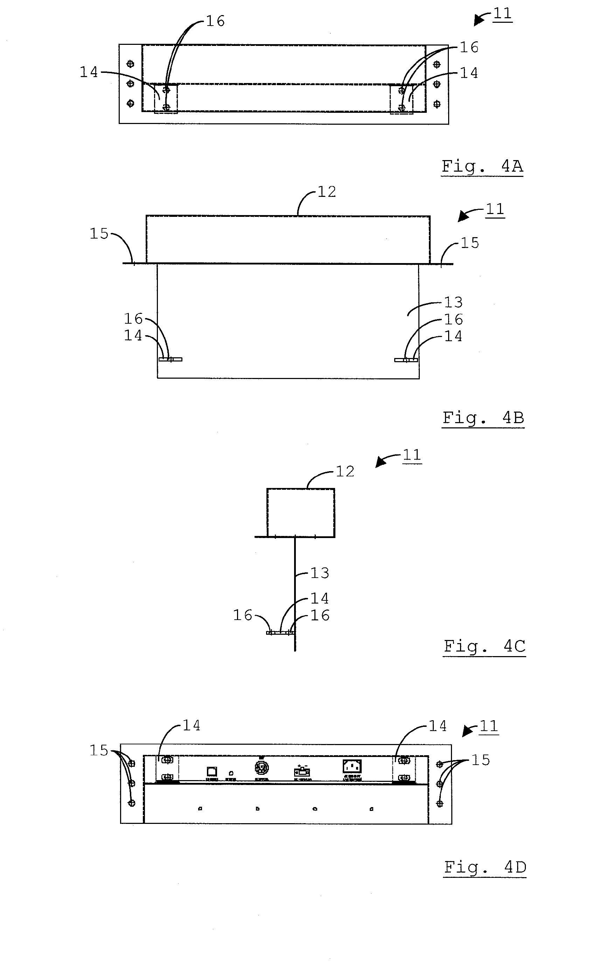

Referring to Figs. 4A-4D, the extension device 11 comprises a cover 12, a frame 13 and two brackets 14. In the illustrated example, the extension device 11 is a single body of which the cover 12, frame 13 and brackets 14 are integral parts. The brackets 14 and cover 12 can, for instance, be welded to the frame 13. In alternative embodiments, the cover 12 is releasably mounted to the frame 13, so that the extension device 11 is properly speaking an assembly of components. In yet another embodiment, the cover 12 and frame 13 are connected separately to the housing 1, but not to each other.

Figs. 2 and 3 show the extension device 11 positioned for installing the equipment module 10 in a position at least partially occupying a cable accommodation space. The extension device, in particular its frame 13, extends through the opening provided in the cable passage area of the second side panel 4.

Referring to Fig. 4A, the extension device 11 is provided with holes 15 for insertion of retention bolts (not shown). The retention bolts provide the mechanism for mounting the cover 12, and thus the rest of the extension device 11, to the exterior surface of the second side panel 4. In the illustrated embodiment, the holes 15 correspond in position and size to those present in the blind plate that the extension device 11 replaces. This has the advantage that only mechanical adaptation of the housing 1 is required. Welding or drilling operations are not called for.

The brackets 14 are similarly provided with holes 16, through which retention screws can be inserted. By these means, the equipment module 10 is fixed in position relative to the extension device. Preferably, the holes 16 are dimensioned and positioned such as to allow a rack-mountable module, preferably a standard-sized nineteen-inch unit, to be mounted in the extension device 11. This has the advantage that a wide range of equipment modules 10 can be installed. Fig. 4D shows the mounted equipment module 10, mounted by means of retention screws inserted into its face plate. Alternative means of mechanically mounting the equipment module 10 into the extension device 11 are used in other embodiments, for example clamps or mechanical connectors attaching the equipment module 10 in a positive way.

The equipment module 10 can perform any desired function. In the context of implementing a node B BTS, it is advantageous if the equipment module 10 is a device in a system for controlling tilt of an antenna in a base transceiver station of a cellular communications system. Another advantageous use of the extension device 11 is for mounting an equipment module 10 comprising a Radio-Frequency (RF) amplifier. In both cases, the equipment module 10 is connected to external devices, so that placement close to the cable passage areas with openings through which cables are fed is advantageous. In the case of a system for controlling antenna tilt, connections are needed to allow remote control, as well as connections to the antenna itself. The placement of, preferably remotely controllable, antenna tilt adjustment systems in equipment enclosures used for second-generation mobile networks is of particular advantage. Without installing an additional housing 1, additional equipment can be installed, saving on costs. By installing a device in a system for controlling antenna tilt, larger cells in a third-generation network can be defined, providing further cost-savings. It is observed that a similar effect is attainable by installing an equipment module including a device for adjusting the phase relationship in an antenna array. In that case too, the antenna pattern of an antenna system at a BTS site can be remotely adjusted for better coverage.

In another implementation, the equipment module 10 is formed by a High-speed Digital Subscriber Line (HDSL) Modem. In this implementation too, the equipment module is a rack-mountable unit for mounting in a standard-sized nineteen inch rack. It is usable to provide a fixed-line connection between the BTS and a Base Station Controller (BSC) in a cellular communications network. In another implementation, the equipment module 10 is formed by an indoor radio unit for microwave communication, which is similarly mountable in a nineteen inch rack.

The invention is not limited to the embodiments described above, which can be varied within the scope of the accompanying claims. For example, brackets configured to provide mounting points for mounting a rack-mountable module can be mounted separately within one of the cable accommodation spaces. In another embodiment, the brackets allow for simultaneously mounting of a plurality of such modules.

## Claims

1. Electrical equipment enclosure including a housing (1), provided on at least two sides with cable passage areas, pre-configured for providing an opening for passing through cables from equipment external to the enclosure,
wherein the housing (1) is adapted to accommodate a connecting device (8) providing access to at least one cable connection point (9), and further including
an extension device (11) for installing an equipment module (10), **characterised in that**
the housing (1) is adapted to accommodate the connecting device (8) in a position defining cable accommodation spaces, extending from at least two sides of the connecting device (8) to cable passage areas on corresponding sides of the housing (1), and **in that**
the extension device (11) is positioned for installing an equipment module (10) in a position at least partially occupying a cable accommodation space.

2. Electrical equipment enclosure according to claim 1, wherein the extension device (11) is releasably mounted to the housing (1).

3. Electrical equipment enclosure according to claim 2, wherein the extension device (11) extends through an opening provided in the cable passage area to which the cable accommodation space extends.

4. Electrical equipment enclosure according to any one of the preceding claims, wherein a cover (12) defining a space expanding the cable accommodation space on an opposite side of the cable passage area to which the cable accommodation space extends, is mounted on an exterior surface of the housing (1).

5. Electrical equipment enclosure according to claim 4, wherein the cover (12) is attached to a side panel (4) of the housing (1) provided with the cable passage area and wherein at least one bracket (14) for mounting an equipment module (10) is provided on a frame (13) extending from the cover (12) into the cable passage area.

6. Electrical equipment enclosure according to any one of the preceding claims, provided with a climate control system for regulating the temperature inside the housing (1).

7. Electrical equipment enclosure according to any one of the preceding claims, wherein a device in a system for controlling an antenna pattern of an antenna system at a site of a base transceiver station of a cellular communications system is mounted in the extension device (11).

8. Electrical equipment enclosure according to any one of the preceding claims, wherein the sides on which cable passage areas are provided extend upwardly relative to a base (2) for mounting the housing (1) on a pedestal.

9. Electrical equipment enclosure according to claim 8, wherein the cable accommodation spaces are defined at an end of the housing (1) opposite to the base (2).

10. Electrical equipment enclosure according to any one of the preceding claims, wherein the extension device (11) includes at least one bracket (14) configured to provide mounting points for mounting a rack-mountable module (10), preferably a standard-sized nineteen-inch unit.

11. Device for extending the accommodation capacity of an enclosure for accommodating electrical equipment, which device comprises an extension device presenting all the features of the extension device disclosed in any one of the preceding claims and being thus constructed and evidently intended for use in the electrical equipment enclosure as claimed in any one of the preceding claims.

12. Method of installing an equipment module in an electrical equipment enclosure including
providing a housing (1) provided on at least two sides with cable passage areas, pre-configured for providing an opening for passing through cables from equipment external to the enclosure,
the housing (1) being adapted to accommodate a connecting device (8) providing access to at least one cable connection point (9), **characterised by**
providing a housing (1) adapted to accommodate the connecting device (8) in a position defining cable accommodation spaces, extending from at least two sides of the connecting device (8) to cable passage areas on corresponding sides of the
housing (1) and mounting the equipment module (10) in a position at least partially occupying a cable accommodation space.

13. Method according to claim 12, wherein an extension device (11) is mounted in the electrical equipment enclosure, and wherein the equipment module (10) is mounted in the extension device (11).

14. Method according to claim 13, including mounting the extension device (11) so as to extend through the opening provided in one of the cable passage areas.
